Europäisches Patentamt

(19) European Patent Office

Office européen des brevets

(11) Publication number: **0 046 371**
**B1**

(12) **EUROPEAN PATENT SPECIFICATION**

(45) Date of publication of patent specification: **14.11.84**   (51) Int. Cl.³: **H 01 L 21/90**

(21) Application number: **81303681.1**

(22) Date of filing: **13.08.81**

(54) **Method of manufacturing a semiconductor device.**

(30) Priority: **13.08.80 JP 111334/80**

(43) Date of publication of application:
**24.02.82 Bulletin 82/08**

(45) Publication of the grant of the patent:
**14.11.84 Bulletin 84/46**

(84) Designated Contracting States:
**DE FR GB NL**

(56) References cited:
**US-A-4 102 733**

**IBM TECHNICAL DISCLOSURE BULLETIN, Vol. 17, No. 6, November 1974 New York V.L. RIDEOUT "Reducing the Sheet Resistance of Polysilicon Lines in Integrated Circuits" pages 1831 to 1833**

(73) Proprietor: **FUJITSU LIMITED**
**1015, Kamikodanaka Nakahara-ku**
**Kawasaki-shi Kanagawa 211 (JP)**

(72) Inventor: **Sasaki, Nobuo**
**1-14-240, Kawara-cho Saiwai-ku**
**Kawasaki-shi Kanagawa, 210 (JP)**
Inventor: **Nakano, Motoo**
**312-3-9-913, Imai-cho Hodogaya-ku**
**Yokohama-shi Kanagawa, 240 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a semiconductor device and a method of manufacturing a semiconductor device.

Multi-layer wiring structures are being employed in semiconductor devices to provide for an increase in the integration density of integrated circuits.

Referring to Figure 1A of the accompanying drawings, which is a schematic cross-sectional view, in a known method of manufacturing a semiconductor device, there is formed a first wiring layer 2, of aluminium for example, on an insulating substrate 1. An insulating layer of phospho-silicate-glass (PSG) 3 is formed over the aluminium wiring layer 2, and a second wiring layer 4 of aluminium is formed on the PSG layer 3.

In this structure, needless to say, aluminium wiring layers 2 and 4 have a resistance of a low value. In the illustrated structure, however, it is generally observed that the wiring layer 2 has steps 2', and because of these steps, both the PSG layer 3 and the second wiring layer 4 tend also to be formed with steps 3' and 4' respectively, as shown. In such a case, the second wiring layer 4 is liable to be broken at steps 4'. Thus, the wiring arrangement of Figure 1A has a weakness in that manufacturing yield cannot easily be improved, although the value of resistance of aluminium is low.

An attempt to anneal the PSG layer 3, to smooth the steps 3', is not satisfactory in this case because, at 500°C, aluminium reacts with the PSG or silicon dioxide with which it is in contact, rendering the aluminium wiring unusable.

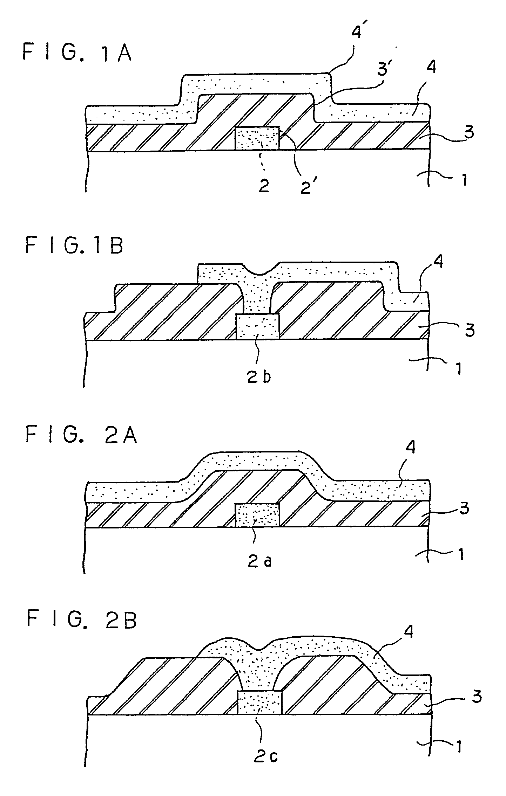

An improvement over the wiring arrangement of Figure 1A is offered by that shown in Figure 2A of the accompanying drawings, which is a schematic cross-sectional view, in which aluminium wiring layer 2 is replaced by a silicon wiring layer 2a. After formation of the PSG layer 3 in Figure 2A, annealing at 1050°C is carried out for reflowing the PSG as shown in Figure 2A. Aluminium wiring layer 4 is then formed on the smooth PSG layer 3. This can avoid breakage of the wiring layer 4 as experienced in the arrangement of Figure 1A.

Thus, the wiring arrangement of Figure 2A can result in an improved manufacturing yield. However, the value of resistance of silicon wiring layer 2a is high compared to that of aluminium wiring layer 2 of Figure 1A.

Similar results are observed at contact holes formed over electrodes 2b and 2c as illustrated in Figures 1B and 2B of the accompanying drawings, which are schematic cross-sectional views. Aluminium wiring layer 2b in Figure 1B is replaced by silicon wiring layer 2c in Figure 2B and the steep edge of PSG in Figure 1B is smoothed in Figure 2B.

It will be understood that efforts have been made to maintain a high manufacturing yield whilst holding down the resistance of multiple wiring layers so much as possible.

In the structures shown in Figure 2A and 2B, it is known generally that single-crystal silicon is preferable to polycrystalline silicon as wiring material, because the value of resistance of single-crystal silicon is half that of polycrystalline silicon. Further, when single-crystal silicon is turned into a metal silicide, the value of its resistance is reduced by one order of magnitude. Formation of silicide wiring can be effected simultaneously with the manufacture of other parts of a semiconductor device without the need for a separate and independent process.

Japanese Unexamined Patent Publication No. 135 583 of 1978, published on 27th November, 1978, discloses a method of manufacturing an insulated-gate field-effect transistor (IGFET). The method is understood to comprise the following steps; masking, with a first mask, a thick insulating layer on a silicon substrate for fabrication of a gate, a source and a drain; to be followed by etching; covering the entire surface of the substrate with a thin layer of insulating material and a layer of polycrystalline silicon, successively; masking, with a second mask, the composite layer structure of polycrystalline silicon and insulating material for removing a part of the composite layer structure in a region where the source and drain are to be formed, to be followed by etching; introducing impurity material into the exposed region where the source and drain are to be formed; covering the entire exposed surface with a layer of metal for forming a silicide; forming a silicide on the polycrystalline silicon layer in the gate region, to form the gate; and forming a silicide on the silicon in the source and drain formation region to form source and drain contacts; and selectively etching that part of the metal layer that has not been turned into silicide.

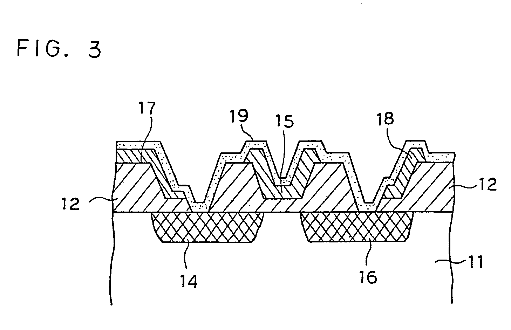

Figure 3 of the accompanying drawings is a schematic cross-sectional view illustrating a structure fabricated by such a method, in which 11 is a substrate of one conductivity type, 12 indicates oxidised layers, 14 and 16 are regions doped with impurity material, 15 is a gate electrode, 17 and 18 are interconnection layers, and 19 is a metal layer.

According to the disclosed method, annealing of the structure as shown in Figure 3 is effected, and parts of the metal layer 19 in contact with silicon are turned into a silicide in a self-alignment fashion, and no reaction is noted in parts of the metal layer 19 not in contact with silicon. There is silicide formation at or near the area over the polycrystalline silicon electrodes 15, 17 and 18 and in a surface area where the metal layer 19 is in contact with the region 14 in the substrate 11.

If the annealing is carried out for a longer period of time for the purpose of silicide formation, the formed silicide will penetrate through the region 14. If this happens, there will be a conductive path between the metal layer 19 and the substrate 11.

Because of this, annealing for silicide formation must be terminated at an appropriate time in this method. This means that it is difficult to regulate the extent or length of annealing in the method described above. Moreover, the method cannot be repeated with certainty and resistivity cannot be reduced sufficiently.

IBM Technical Disclosure Bulletin, Volume 17, No. 6, November 1974, pages 1831 to 1833 discloses a method of manufacturing a semiconductor device involving the conversion of polysilicon to silicide-polysilicon so as to reduce the resistance of polysilicon conductor lines on an insulating substrate. Hafnium silicide is suggested for such use. Other silicides are mentioned as possibly practical.

According to the present invention there is provided a method of manufacturing a semiconductor device comprising the steps of:

. forming a single crystal silicon layer on an insulating substrate,
. patterning said single crystal silicon layer to form an active element region and a first wiring region,
. forming a gate insulating film on said regions,
. forming a polycrystalline silicon film over said substrate,
. patterning said polycrystalline silicon film to form a gate electrode region over said active element region and to form a second wiring region,
. introducing one type of impurity material by blanket ion implantation to said first wiring region, to said second wiring region, to said gate electrode region and to said active element region except beneath said gate electrode region,
. removing said gate insulating film from said first wiring region,
. forming a metal layer over said substrate in contact with said first wiring region, said second wiring region and said gate electrode region,
. carrying out an annealing to form a metal silicide by converting the parts of said first wiring region, said second wiring region and said gate electrode region in contact with metal into metal silicide throughout their entire thicknesses, and
. removing said metal layer after the formation of said metal silicide in the annealing step.

An embodiment of this invention can provide a method of manufacturing a semiconductor device provided with electrodes and wiring of a low value of resistance.

The inventors of the present invention have taken regard of the fact that both single-crystal and polycrystalline silicon wiring can be completely turned into silicides, resulting in the provision of wiring of low resistance if they are on insulating substrates. By silicide formation for polycrystalline silicon wiring, as well as for single-crystal wiring, the operational speed of a device can be improved in addition to integration density.

In one embodiment of the present invention, silicon wiring such as that shown at 2a, and electrodes such as that shown at 2c, in Figures 2A and 2B, are turned into silicides such as $MoSi_2$ or PtSi to obtain a low value of resistance, which low value is somewhere between the values of resistance of aluminium and silicon.

In a further embodiment of the present invention, a silicon layer is formed on an insulating layer of sapphire or spinel that has been deposited on a semiconductor substrate.

An embodiment of the present invention provides a method, including the steps of: exposing a part of a single-crystal or polycrystalline silicon layer formed on an insulating substrate, depositing a film of metal over the silicon layer and annealing to form silicide of the metal, for the purpose of reducing the resistance of the single-crystal or polycrystalline silicon layer which is used as interconnection wiring or electrodes.

Reference is made, by way of example, to the accompanying drawings, in which:—

Figures 1A and 1B are respective schematic cross-sectional views illustrating two layer aluminium wiring or electrode structures as formed by a known method,

Figures 2A and 2B are respective schematic cross-sectional views illustrating silicon/aluminium wiring or electrode structures as formed by another known method,

Figure 3 is a schematic cross-sectional view of an IGFET formed by a known method,

Figures 4 to 10 are respective cross-sectional views of relevant parts of a semiconductor device at various stages in its manufacture according to a method embodying the present invention, and

Figure 11 is a plan view of a part of a semiconductor device manufactured according to a method embodying the present invention.

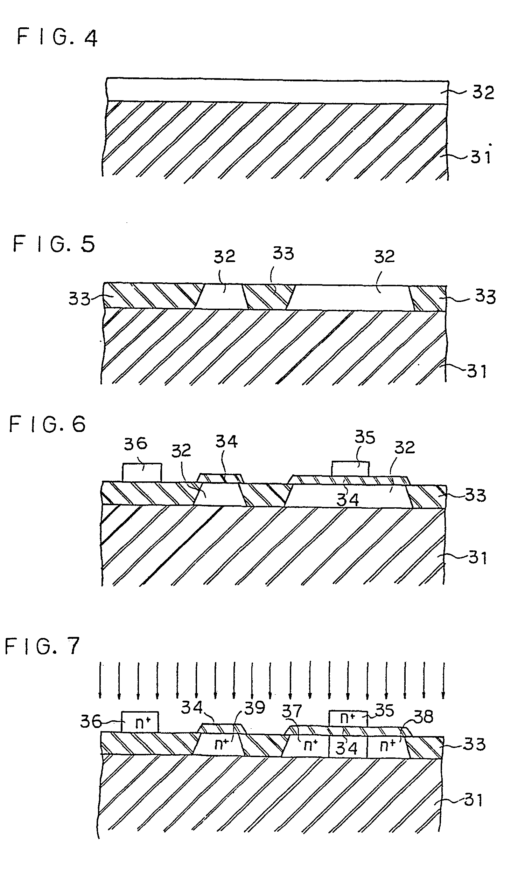

There are illustrated in the cross-sectional views of Figures 4 to 10 relevant parts of a semiconductor device at various stages in a manufacturing process in accordance with a method embodying the present invention.

Referring first to Figure 4, a layer 32 of single-crystal silicon is epitaxially grown, to a thickness of approximately 0.6 $\mu$m on the surface of a single-crystal insulating substrate 31, of sapphire for example.

In order to isolate regions where active elements of the semiconductor device are to be fabricated, insulating films 33 are formed as formed as shown in Figure 5 by a known thermal process of local oxidisation of silicon (LOCOS) using a mask of silicon nitride, for example.

As shown in Figure 6, an insulating film 34, approximately 50 nm 500 Å thick, is next formed, by a conventional thermal oxidation process. The film 34 may be used as a gate insulating film of a transistor to be fabricated subsequently.

By a known chemical vapour deposition (CVD) process, a polycrystalline silicon film is grown to a thickness of approximately 800 nm (8000 Å). This film is then patterned in accordance with a known photolithography process to form a silicon gate electrode 35 and wiring 36.

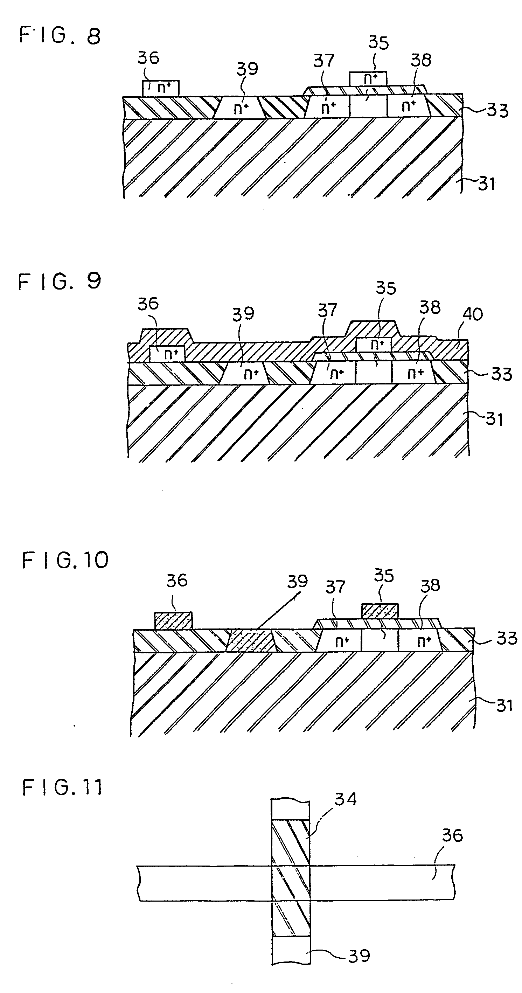

Next, as illustrated by arrows in Figure 7, n-type impurity material, such as arsenic (As$^+$), is introduced by a known blanket ion implantation process, at an energy of 150 KeV, and a dosage of $5 \times 10^{15} cm^{-2}$, to form an n$^+$-type source region 37 and an n$^+$-type drain region 38. An n$^+$-type region 39 is used for wiring purposes. The gate electrode 35 and the wiring 36 are also simultaneously doped with n$^+$-type impurity material.

By a known photolithography process, the insulation film 34 is patterned to expose the surface of the wiring region 39 as shown in Figure 8.

Further, by a conventional sputtering process, a molybdenum (Mo) film 40 is grown to a thickness of approximately 1000 nm (10000 Å), as shown in Figure 9. As alternatives to molybdenum, metals such as titanium, platinum, nickel, magnesium, iron, hafnium, rubidium, vanadium and the like may be used singly or together.

Then, annealing is carried out in a nitrogen atmosphere at approximately 600°C to turn the silicon gate electrode 35, wiring 36, and wiring region 39 into Mo silicide. There is no silicide formation in any of the parts of the Mo film in contact with silicon dioxide, and only exposed silicon layer portions or regions are turned into silicide, in a self-alignment fashion.

Referring to Figure 9, the substrate 31 is made of an insulating material. There is a film of silicon dioxide under the electrode 35 and under wiring 36. Thus, annealing can be carried out for a sufficiently long time to form silicide throughout the entire thickness of silicon films 35, 36 and 39, resulting in a lower value of resistance therefor. This is an improvement not disclosed in the unexamined Japanese Patent Publication No. 135 583 of 1978, mentioned previously.

Finally, as shown in Figure 10, further annealing is carried out in an oxidation atmosphere of oxygen gas diluted by nitrogen gas at 300°C to convert Mo film 40 into a film of molybdenum oxide. As is generally known, molybdenum oxide is volatile and evaporates, but the molybdenum silicide remains in place.

Alternatively, Mo film 40 may be removed by a known chemical etching process, utilising the difference in etching rates of Mo and MoSi$_2$ in which case dilute nitric or sulphuric acid may be used. Platinum, if used instead of Mo, may be removed by aqua regia.

Then, PSG is deposited, contact holes are opened, and aluminium is evaporated and patterned to complete a semiconductor device.

Wiring 36 and the wiring region 39 may cross each other as shown by the plan view of Figure 11. In such a case, silicon dioxide film 34 on the wiring region 39, at the region at which wiring 36 and region 39 cross, is not removed and remains in position as shown by hatching in Figure 11. This means that the region 39 under the silicon dioxide 34 and the wiring 36 will not be turned into silicide and will remain as single-crystal silicon having a higher value of resistance than that of the silicide.

Even in such a case, since the width of the wiring 36 is usually only of the order of 4 to 5 $\mu$m, whereas the length of wiring 39 is of the order of millimeters, although the value of resistance of that portion of wiring 39 at such a crossing place is not reduced, due to the large dimensional difference just mentioned, the effect of the absence of formation of silicide at the crossing portion of the wiring 36 and region 39 is negligible, and the device as a whole is very little affected thereby.

In the embodiment of the present invention, that has been described above, the layer 32 of single-crystal silicon, for formation of active elements such as MOS FET's is epitaxially grown on a sapphire substrate 31. Alternatively, a silicon substrate having a film of silicon dioxide, approximately 6000 Å thick, grown thereon may be used as insulating substrate 31. A film of single-crystal silicon approximately 5000 Å thick may be formed on the film of silicon dioxide for formation of the active elements.

In this case, a film of polycrystalline silicon, 500 nm (5000 Å) thick, deposited on the film of silicon dioxide, may be turned into single-crystal silicon film by a known regrowth process using laser annealing, electron beam annealing or the like.

As an alternative, a film of sapphire or spinel, 600 nm (6000 Å) thick, may be grown epitaxially on a single-crystal silicon substrate. In this case, silicon film 500 nm (5000 Å thick), may be epitaxially grown on the sapphire film for formation of active regions.

Experiments have confirmed that the sheet resistance of a heavily doped single-crystal silicon film 500 nm (5000 Å) thick, is about 20Ω/square. When such silicon film is turned into a silicide film, the sheet resistance thereof is about 3Ω/square.

As will be understood from the foregoing description, an electrode or wiring usually formed of silicon is partly exposed in accordance with a method embodying the present invention, and a film of metal capable of forming silicide when alloyed with silicon is formed on the electrode or wiring. Then annealing is carried out. The silicon electrode or wiring is turned into a silicide electrode or wiring, for example an electrode or wiring of MoSi$_2$, of which the resistance is reduced considerably.

## Claims

1. A method of manufacturing a semiconductor device comprising the steps of:

. forming a single crystal silicon layer (32) on an insulating substrate (31),
. patterning said single crystal silicon layer to form an active element region and a first wiring region,
. forming a gate insulating film (34) on said regions,
. forming a polycrystalline silicon film over said substrate,
. patterning said polycrystalline silicon film to form a gate electrode region (35) over said active element region and to form a second wiring region (36),
. introducing one type of impurity material by blanket ion implantation to said first wiring region, to said second wiring region, to said gate electrode region and to said active element region except beneath said gate electrode region,
. removing said gate insulating film from said first wiring region,
. forming a metal layer (40) over said substrate in contact with said first wiring region, said second wiring region and said gate electrode region,
. carrying out an annealing to form a metal silicide by converting the parts of said first wiring region, said second wiring region and said gate electrode region in contact with metal into metal silicide throughout their entire thicknesses, and
. removing said metal layer after the formation of said metal silicide in the annealing step.

2. A method as claimed in claim 1, wherein the insulating substrate comprises sapphire or spinel.

3. A method as claimed in claim 1, wherein the insulating substrate comprises a single-crystal silicon substrate and a film of silicon dioxide formed on the silicon substrate.

4. A method as claimed in claim 1, wherein the insulating substrate comprises a semiconductor substrate with a film of sapphire or spinel formed on the semiconductor substrate.

5. A method as claimed in claim 1, wherein the insulating substrate comprises a single-crystal silicon substrate with a film of sapphire or spinel formed on the silicon substrate.

6. A method as claimed in any preceding claim, wherein the metal film consists of at least one of the following metals:— molybdenum, titanium, platinum, nickel, magnesium, iron, hafnium, rubidium, vanadium.

7. A method as claimed in claim 1, wherein said patterning of the single crystal silicon layer is performed by local oxidation process.

8. A method as claimed in claim 1, wherein said patterning of the polycrystalline film is performed by a photo-etching process.

## Patentansprüche

1. Verfahren zur Herstellung eines Halbleiterbauelements, gekennzeichnet durch die folgenden Schritte:

— Bildung einer Siliziumeinkristallschicht (32) auf einem isolierenden Substrat (31),
— Musterung der genannten Siliziumeinkristallschicht um einen Bereich für ein aktives Element und einen ersten Verdrahtungsbereich zu bilden,
— Bildung einer Gate-Isolierschicht (34) auf den genannten Bereichen,
— Bildung einer polykristallinen Siliziumschicht über dem genannten Substrat,
— Musterung der genannten polykristallinen Siliziumschicht, um einen Gateelektrodenbereich (35) über dem genannten aktiven Element und um einen zweiten Verdrahtungsbereich (36) zu bilden,
— Einführung einer Art eines Verunreinigungsmaterials durch Überlagerungs-Ionenimplantation zu dem genannten ersten Verdrahtungsbereich, zu dem zweiten Verdrahtungsbereich, zu dem genannten Gateelektrodenbereich und zu dem Aktivelementbereich, mit Ausnahme unterhalb des genannten Gateelektrodenbereichs,
— Entfernung der Gate-Isolierschicht von dem genannten ersten Verdrahtungsbereich,
— Bildung einer Metallschicht (40) über dem genannten Substrat in Kontakt mit dem genannten ersten Verdrahtungsbereich, dem genannten zweiten Verdrahtungsbereich und dem genannten Gateelektrodenbereich,
— Durchführung einer Wärmebehandlung, um durch Konvertierung der Teile des genannten ersten Verdrahtungsbereichs, des genannten zweiten Verdrahtungsbereichs und des genannten Gateelektrodenbereichs, die mit dem Metall in Berührung sind, in Metallsilizid durch ihre gesamte Dicke ein Metallsilizid zu bilden, und
— Entfernung der genannten Metallschicht nach Bildung des genannten Metallsilizids in dem Wärmebehandlungsschritt.

2. Verfahren nach Anspruch 1, bei welchem das isolierende Substrat Saphir oder Spinell umfaßt.

3. Verfahren nach Anspruch 1, bei welchem das isolierende Substrat ein einkristallines Siliziumsubstrat oder eine auf dem Siliziumsubstrat gebildete Schicht aus Siliziumdioxid umfaßt.

4. Verfahren nach Anspruch 1, bei welchem das isolierende Substrat ein Halbleitersubstrat mit einer auf dem Halbleitersubstrat gebildeten Schicht auf Saphir oder Spinell umfaßt.

5. Verfahren nach Anspruch 1, bei welchem das isolierende Substrat ein einkristallines Siliziumsubstrat mit einer auf dem Siliziumsubstrat gebildeten Schicht aus Saphir oder Spinell umfaßt.

6. Verfahren nach einem der vorhergehenden Ansprüche, bei welchem die Metallschicht aus wenigstens einem der folgenden Metalle besteht:— Molybdän, Titan, Platin, Nickel, Magnesium, Eisen, Hafnium, Rubidium, Vanadium.

7. Verfahren nach Anspruch 1, bei welchem die genannte Musterung der einkristallinen Siliziumschicht durch ein lokales Oxidationsverfahren durchgeführt wird.

8. Verfahren nach Anspruch 1, bei welchem die genannte Musterung der polykristallinen Schicht mit Hilfe eines Fotoätzverfahrens durchgeführt wird.

**Revendications**

1. Procédé pour fabriquer un dispositif à semiconducteurs, comprenant les étapes suivantes:

— former une couche de silicium monocristallin (32) sur un substrat isolant (31),

— constituer de cette couche de silicium monocristallin une région d'élément actif et une première région de connexion,

— former un film (34) d'isolation de grille sur ces régions,

— former un film de silicium polycristallin sur le substrat,

— constituer de ce film de silicium polycristallin une région d'électrode de grille (35) au-dessus de la région d'élément actif et une seconde région de connexion (36),

— introduire une impureté de type déterminé par implantation ionique à recouvrement dans la première et la seconde région de connexion, la région d'électrode de grille et la région d'élément actif, sauf sous la région d'électrode de grille,

— enlever le film d'isolation de grille de la première région de connexion,

— former une couche métallique (40) sur le substrat et en contact avec les régions de connexion et d'électrode de grille,

— effectuer une recuisson pour transformer les parties en contact avec le métal des régions de connexion et d'électrode de grille en siliciure sur toute leur épaisseur, et

— enlever la couche métallique après la formation du siliciure lors de la recuisson.

2. Procédé selon la revendication 1, où le substrat isolant est en saphir ou spinelle.

3. Procédé selon la revendication 1, où le substrat isolant est constitué d'un substrat de silicium monocristallin sur lequel est déposé un film de dioxyde de silicium.

4. Procédé selon la revendication 1, où le substrat isolant est constitué d'un substrat semiconducteur sur lequel est déposé un film de saphir ou spinelle.

5. Procédé selon la revendication 1, où le substrat isolant est constitué d'un substrat de silicium monocristallin sur lequel est formé un film de saphir ou de spinelle.

6. Procédé selon l'une quelconque des revendications précédentes, où le film métallique est constitué d'au moins l'un des métaux suivants: molybdène, titane, platine, nickel, magnésium, fer, hafnium, rubidium, vanadium.

7. Procédé selon la revendication 1, où la constitution de la région d'élément actif et de la première région de connexion à partir de la couche de silicium monocristallin est réalisée par une opération d'oxydation locale.

8. Procédé selon la revendication 1, où la constitution de la région d'électrode de grille et de la seconde région de connexion à partir du film de silicium polycristallin est réalisée par une opération de photogravure.

FIG. 1A

FIG. 1B

FIG. 2A

FIG. 2B

FIG. 3

FIG. 4

~32

~31

FIG. 5

32    33    32

33~                    ~33

~31

FIG. 6

36  32  34        35  32

                34            ~33

~31

FIG. 7

36~  n⁺   34  39  37      n⁺  35  38

n⁺        n⁺  34  n⁺      ~33

~31

FIG. 8

FIG. 9

FIG.10

FIG.11